# EUROPÄISCHE PATENTSCHRIFT

(11) **EP 0 957 509 B1**
(45) Veröffentlichungstag und Bekanntmachung des Hinweises auf die Patenterteilung: **05.09.2007**
(21) Anmeldenummer: 99107921.1
(22) Anmeldetag: 22.04.1999
(51) Int. Cl.: B81C 1/00, B81B 3/00, H01L 21/306, H01L 21/308

(54) **Verfahren zur Herstellung eines Bauteils, das eine mikrostrukturierte Schicht aus Formgedächtnislegierung enthält**
Method of manufacturing a device comprising a micro-structured layer of shape memory alloy
Procédé de fabrication d'un composant comprenant une couche micro-structurée en alliage à mémoire de forme

(30) Priorität: 15.05.1998 DE 19821841
(43) Veröffentlichungstag der Anmeldung: 17.11.1999
(73) Patentinhaber: Forschungszentrum Karlsruhe GmbH, 76133 Karlsruhe (DE)
(72) Erfinder: Skrobanek, Klaus Dr., 72827 Wannweil (DE); Kohl, Manfred Dr., 76149 Karlsruhe (DE); Quandt, Eckhard Dr., 76356 Weingarten (DE)

(56) Entgegenhaltungen:
- EP-A- 0 506 146
- SINGH A ET AL: "Batch Transfer of Microstructures Using Flip-Chip Solder Bump Bonding" IEEE SOLID STATE SENSORS AND ACTUATORS CONFERENCE (TRANSDUCERS '97), CHICAGO, IL, USA, 16-19 JUN, Seiten 265-268 vol.1, XP002125409 ISBN: 0-7803-3829-4
- SCHOMBURG W K ET AL: "3.5 um thin valves in titanium membranes" JOURNAL OF MICROMECHANICS AND MICROENGINEERING, SEPT. 1992, UK, Bd. 2, Nr. 3, Seiten 184-186, XP000856098 ISSN: 0960-1317
- CALLAHAN J J ET AL: "Alignable liftoff transfer of device arrays via a single polymeric carrier membrane" ELECTRONICS LETTERS, 27 MAY 1993, UK, Bd. 29, Nr. 11, Seiten 951-953, XP002125410 ISSN: 0013-5194

## Beschreibung

Die Erfindung betrifft ein Verfahren zur Herstellung eines Bauteils, das eine mikrostrukturierte Schicht enthält gemäß dem ersten Patentanspruch.

Singh A et al beschreiben in "Batch Transfer of Microstructures Using Flip-Chip Solder Bump Bonding" IEEE SOLID STATE SENSORS AND ACTUATORS CONFERENCE (TRANSDUCERS '97), CHICAGO USA, 16-19 June, Seiten 265-268 vol. 1, XP002125409 ISBN: 0-7803-3829-4 eine Methode zum Aufbau von Mikrostrukturen mit Hilfe der Opferschichttechnik auf einem zweiten Substrat. Auf der Oberfläche eines beständigen ersten Substrats, dem Hilfssubstrat, wird eine Opferschicht aufgetragen und auf dieser Opferschicht eine mikrostrukturierte Schicht aufgebaut. Dabei liegt ein zentraler Bereich der mikrostrukturierten Schicht unmittelbar über der Opferschicht. Die mikrostrukturierte Schicht wird anschließend auf ein zweites Substrat übertragen, indem die Opferschicht selektiv weggeätzt wird und die Verbindungen der mikrostrukturierten Schicht mit dem Hilfssubstrat unterbrochen werden.

In der Veröffentlichung von A. D. Johnson: "Vacuum-deposited TiNi shape memory film: characterization and applications in microdevices", J. Micromech. Microeng. 1 (1991) 34-41 wird die Herstellung von Aktoren beschrieben, die Membranen aus der Formgedächtnislegierung TiNi enthalten. Die Membranen werden direkt durch Abstäuben hergestellt. Infolge einer Kontamination mit Sauerstoff sinkt die Umwandlungstemperatur stark ab. Deshalb wird alternativ zuerst eine amorphe Schicht aus TiNi hergestellt, die anschließend bei ca. 500°C die gewünschte Formgedächtniseigenschaft erhält. Das Problem bei diesem Verfahren besteht darin, daß das Substrat, auf dem die amorphe Schicht aufgetragen ist, entsprechend temperaturbeständig sein muß. Deshalb ist die Materialauswahl für das Substrat praktisch auf Silicium beschränkt.

Bei einem anderen Verfahren (A. D. Johnson, E. J. Shahoian: "Progress in thin film shape memory microactuators", Proceedings of IEEE/MEMS '95 Amsterdam, P 216-220) wird zur Herstellung einer Schicht aus Formgedächtnislegierung ein Hilfssubstrat eingesetzt, das anschließend entfernt wird. Hierbei werden in einem Wafer durch naßchemisches Ätzen auf einer Seite mehrere Vertiefungen geschaffen. Von der anderen Seite aus gesehen bildet das restliche Silicium an der Stelle der Vertiefungen eine dünne Membran. Auf diese andere Seite wird anschließend eine Schicht aus TiNi aufgestäubt, wärmebehandelt und mikrostrukturiert, wobei gegebenenfalls bereits elektrische Kontakte aus Gold vorgesehen werden. Danach wird auch das restliche Silicium im Bereich der Vertiefungen entfernt und der Wafer vereinzelt. Bei diesem Verfahren muß das Substrat in zwei Schritten vollständig beseitigt werden. Ein weiterer Nachteil ist die Maximaldehnung des Siliciums von ca. 0,1 %. Dies kann im Verbund mit Bauteilen aus einer Formgedächtnislegierung, die eine Maximaldehnung von mehreren Prozent aufweisen, zu Problemen führen.

Der Erfindung liegt die Aufgabe zugrunde, ein Verfahren vorzuschlagen, mit dessen Hilfe eine Schicht eines Materials, während dessen Herstellung aggressive Bedingungen erforderlich sind, mit einem Substrat verbunden werden kann, das diese aggressiven Bedingungen an sich nicht notwendigerweise übersteht. Das vorzuschlagende Verfahren soll demnach ungeachtet der aggressiven Bedingungen bei der Herstellung für das Substrat eine breite Palette von einsetzbaren Materialien ermöglichen.

Die Aufgabe wird erfindungsgemäß durch das im ersten Patentanspruch beschriebene Verfahren gelöst. In den weiteren Patentansprüchen sind bevorzugte Ausgestaltungen des Verfahrens beschrieben.

Erfindungsgemäß wird ein Verfahren zur Herstellung eines Bauteils, das eine Funktionsschicht enthält, beschrieben. Die Funktionsschicht stellt eine Schicht aus einer Formgedächtnislegierung dar. Die Funktionsschicht kann sowohl mikrostrukturiert als auch unstrukturiert sein. Unstrukturierte Schichten werden beispielsweise als Membranen eingesetzt. Mikrostrukturierte Funktionsschichten werden insbesondere dann verwendet, wenn mit einem einzelnen Herstellungsschritt mehrkomponentige Bauteile hergestellt werden sollen oder wenn in die Funktionsschicht weitere Komponenten enthalten soll.

Das Verfahren geht von einem ersten Substrat aus, das nur als Hilfssubstrat dient und später abgetrennt wird. Das erste Substrat muß thermisch und mechanisch ausreichend beständig sein, damit die weiteren Verfahrensschritte ohne Beschädigung des Substrats durchgeführt werden können. Als erstes Substrat eignet sich insbesondere ein Substrat aus Aluminiumoxid. Es ist für praktisch alle Anwendungsfälle ausreichend beständig gegenüber hohen Temperaturen, mechanischen Beanspruchungen und chemischen Reagenzien. Es weist einen ähnlichen Wärmeausdehnungskoeffizienten auf wie die Formgedächtnislegierung TiNi; außerdem haften metallische Schichten, insbesondere Schichten aus TiNi, gut auf Aluminiumoxid.

Eine der Oberflächen eines solchen Substrats wird mit einer Opferschicht überzogen. Als Opferschicht eignet sich besonders Gold, weil sich Gold selektiv gegenüber vielen anderen Metallen und Metalllegierungen mit Hilfe einer wäßrigen Ätzlösung aus Kaliumjodid und Jod auflösen läßt. Die Opferschicht kann im Prinzip mit beliebigen Verfahren aufgetragen werden. Vorzugsweise wird die Opferschicht durch eine Maske aufgestäubt. Dieser Verfahrensschritt erspart ein nachträgliches naßchemisches Strukturieren der Opferschicht. Vorzugsweise wird eine aufgestäubte Opferschicht aus Gold bei erhöhten Temperaturen, etwa bei 800°C, beispielsweise eine Stunde lang getempert. Dadurch wird die amorph abgeschiedene Goldschicht rekristallisiert, wodurch das Gold mit der Ätzlösung reproduzierbar zu entfernen ist. Bei amorphen Goldschichten kann die Ätzlösung versagen. Auf die Temperung kann verzichtet werden, wenn entsprechende Abstäubebestimmungen gewählt werden.

Die Strukturierung der Opferschicht erfolgt in der Weise, daß Randbereiche der Oberfläche des ersten Substrats freibleiben. Die Opferschicht kann beispielsweise in der Mitte der Oberfläche angeordnet werden, so daß rings um die Opferschicht Randbereiche freibleiben. Es ist jedoch auch ausreichend, wenn zwei isolierte, vorzugsweise einander gegenüberliegende Randbereiche auf der Oberfläche des Substrats freibleiben.

Auf der Oberfläche des Substrats wird nun mit den Methoden der Mikrostrukturtechnik eine mikrostrukturierte Schicht aufgebaut. Diese Schicht kann im Prinzip mit dem sogenannten LIGA-Verfahren durch Auftragen eines Röntgenresists, Bestrahlen, selektives Entfernen der bestrahlten Bereiche und anschließendes galvanisches Auffüllen mit einem Metall hergestellt und strukturiert werden, sofern für einen elektrisch leitenden Untergrund als Kathode gesorgt wird. Vorzugsweise wird jedoch eine Schicht ganzflächig sowohl über die Opferschicht als auch über die Randbereiche aufgestäubt. Eine solche Schicht kann beispielsweise aus der Formgedächtnislegierung TiNi bestehen. Eine TiNi-Schicht soll anschließend bei erhöhter Temperatur, etwa bei 550°C bis 750°C, längere Zeit, z. B. etwa eine Stunde lang, getempert werden; sie läßt sich anschließend durch elektrolytisches Photoätzen strukturieren. Hierzu wird die Schicht entweder durch ein Tauch- oder ein Schleuderverfahren mit einem Lack überzogen und der Lack über eine Maske belichtet, wonach die belichteten Teile des Lacks chemisch selektiv entfernt werden. Die freigelegten Bereiche der Schicht können dann chemisch abgeätzt werden.

Das Muster, mit der die Schicht mikrostrukturiert wird, wird entsprechend der gewünschten Funktionsschicht gewählt, wobei die Mikrostrukturierung bei gleichzeitiger Herstellung mehrerer Bauteile die einzelnen Funktionsschichten ergeben muß. Eine Mikrostrukturierung ist auch dann erforderlich, wenn die Funktionsschicht des Bauteils mehrere Funktionen in sich vereinigen soll. Wird nur ein einziges Bauteil mit einer Membran als Funktionsschicht hergestellt, braucht der Bereich der Schicht, der die Funktionsschicht ergibt, nicht mikrostrukturiert werden.

Der zentrale Bereich der mikrostrukturierten Schicht, der später die Funktionsschicht bildet, liegt unmittelbar über der Opferschicht. Er läßt sich deshalb später leicht vom Substrat lösen. Die mikrostrukturierte Schicht besteht außerdem noch aus einem peripheren Bereich, unter den sich die Opferschicht nicht erstreckt und der - abgesehen von gegebenenfalls notwendigen Schichten zur Haftvermittlung - unmittelbar auf dem Substrat aufliegt. Der periphere Bereich soll während des gesamten Herstellungsverfahrens sicher auf dem Substrat haften.

Der zentrale und der periphere Bereich der mikrostrukturierten Schicht sind über Stege miteinander verbunden. Die Zahl und die Gestalt der Stege ist an sich von untergeordneter Bedeutung. Die Stege sollen während des Herstellungsverfahrens den zentralen und den peripheren Bereich der mikrostrukturierten Schicht sicher miteinander verbinden, später jedoch eine Trennung der Bereiche ermöglichen, indem die Stege zerbrochen werden. Im einfachsten Fall können stabförmige Stege, deren Zahl mindestens der Zahl der Randbereiche entsprechen soll, vorgesehen werden. Zumindest ein Teil der Stege soll über der Opferschicht angeordnet werden.

Die Opferschicht wird nun selektiv entfernt. Für Gold als Opferschicht eignet sich die bereits erwähnte Ätzlösung. Für Opferschichten aus einem anderen Material wird eine Ätzlösung eingesetzt, die zwar die Opferschicht, nicht aber die mikrostrukturierte Schicht und das Substrat angreift.

Danach wird der zentrale Bereich, der als Funktionsschicht dienen soll, mit einem zweiten Substrat verbunden. Das zweite Substrat kann aus einem Kunststoff bestehen, an den keine besonderen Anforderungen hinsichtlich der thermischen oder chemischen Beständigkeit zu stellen sind. Als zweites Substrat kann für Funktionsschichten, die Membranen darstellen, beispielsweise ein Gehäuse für die Membran verwendet werden. Das zweite Substrat wird mit einer geeigneten Technik, beispielsweise Kleben, mit dem zentralen Bereich der mikrostrukturierten Schicht verbunden.

An sich wäre es zwar möglich, die Opferschicht erst jetzt zu entfernen. Der Nachteil eines solchen Vorgehens besteht jedoch darin, daß in diesem Fall das zweite Substrat zwangsläufig mit der Ätzlösung für die Opferschicht in Berührung kommt und dadurch Schaden nehmen könnte.

Der zentrale Bereich der mikrostrukturierten Schicht läßt sich nun leicht durch Zerbrechen der Stege mitsamt dem damit verbundenen zweiten Substrat isolieren.

Die Erfindung wird im folgenden anhand von Figuren und eines Ausführungsbeispiels näher erläutert.
- Fig. 1: zeigt verschiedene Zwischenschritte des Verfahrens;
- Fig. 2: zeigt ein Bauteil in Explosionsdarstellung.

### Beispiel:

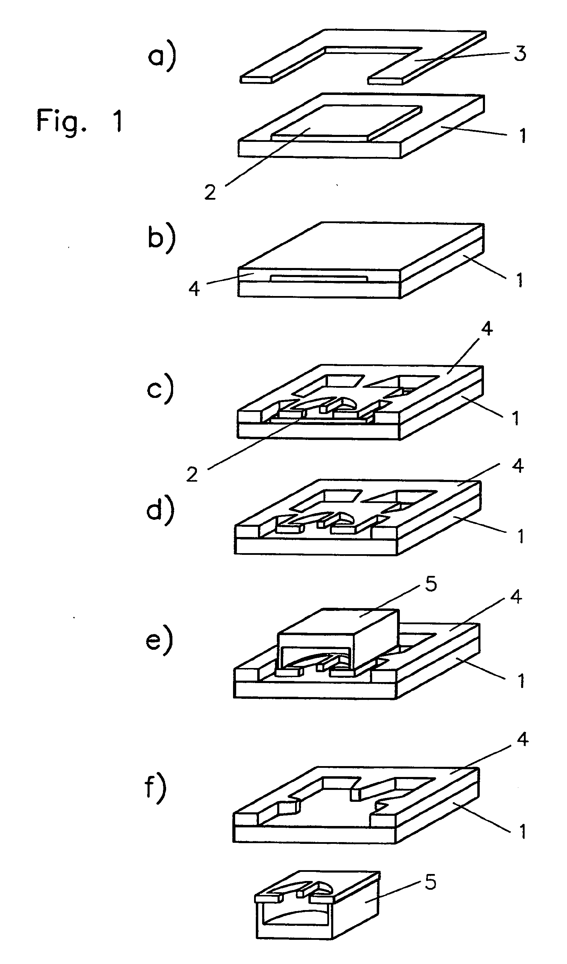

In Fig. 1 ist das Verfahren schematisch einschließlich verschiedener Zwischenstadien dargestellt. Auf einem Substrat 1 aus Al₂O₃ mit den Abmessungen 58 x 29 x 0,6 mm³ wurde über eine Maske 3 eine Opferschicht 2 auf 300 nm dickem Gold aufgetragen, so daß an drei Seiten des Substrates Randbereiche freiblieben (Schritt a)).

In Schritt b) wird eine NiTi-Schicht ganzflächig auf das Substrat aufgestäubt, wobei ein zentraler Bereich der Schicht über der Opferschicht 2 und ein peripherer Bereich der Schicht über den Randbereichen liegen. Die NiTi-Schicht wird anschließend bei 550°C eine Stunde lang im Vakuum rekristallisiert.

Anschließend wird in Schritt c) die NiTi-Schicht durch elektrolytisches Photoätzen strukturiert. Dabei wird auf dieser Schicht Lack entweder mit Hilfe eines Tauchverfahrens oder eines Schleuderverfahrens aufgetragen. Der Lack wird dann in üblicher Weise belichtet und entwickelt, wobei die belichteten Teile des Lackes entfernt werden. Durch die damit geschaffene Lackmaske werden die freigelegten Teile der NiTi-Schicht selektiv weggeätzt und danach der Lack vollständig entfernt. Teil c) von Fig. 1 zeigt diesen Zustand.

Im nun folgenden Schritt d) wird die Goldopferschicht 2 selektiv herausgelöst. Damit erhält man einen freitragenden zentralen Bereich der NiTi-Schicht, der über Haltestege mit dem unmittelbar auf die Randbereiche aufgebrachten peripheren Bereiche der NiTi-Schicht verbunden ist. Als Ätzmittel für Gold wurde eine wäßrige Lösung aus 200 g/l Kaliumjodid und 100 g/l Jod verwendet.

Schließlich wird in Schritt e) als zweites Substrat ein Aktorgehäuse 5 mit dem zentralen Bereich der NiTi-Schicht verklebt. Das Gehäuse 5 enthält bereits eine Polyimid-Membran (nicht dargestellt), die mit Hilfe der Kapillarklebetechnik mit dem zentralen Bereich der NiTi-Schicht verbunden wird. Dabei wird das Gehäuse 5 auf den zentralen Bereich gelegt und dann der Klebstoff dosiert von der Seite an den Klebespalt herangeführt. Er zieht sich dann auf Grund von Kapillarkräften in den Klebespalt. Durch die Klebstoffmenge kann die gewünschte Größe der Klebefläche eingestellt werden.

Schließlich wird im Schritt f) das Gehäuse 5 mit dem zentralen Bereich der NiTi-Schicht abgehoben. Hierzu werden zunächst die Haltestege manuell aufgetrennt und das Gehäuse dann vom Substrat 1 entfernt. Bei entsprechend schwacher Auslegung der Haltestege kann das manuelle Auftrennen enfallen, da hier beim Entfernen des Gehäuses 5 die Stege von allein brechen und das Bauteil freigeben.

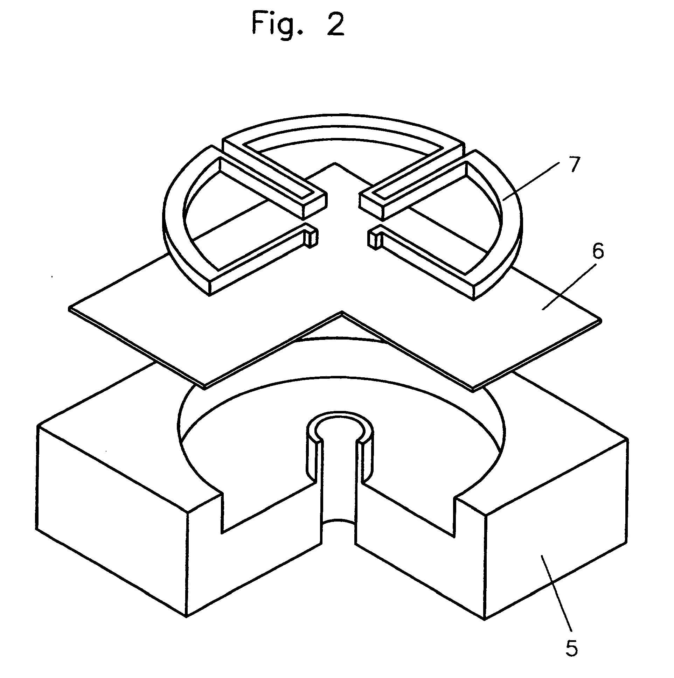

Fig. 2 zeigt einen mit dieser Technik hergestellten Mikromembranaktor, der für Mikropumpen oder Mikroventile eingesetzt werden kann. Der Mikromembranaktor besteht aus einem Verbund eines Gehäuses 5 aus PMMA und einer Polyimid-Membran 6, auf die eine NiTi-Mikrostruktur 7 aufgeklebt ist. Die Mikrostruktur entspricht dem strukturierten zentralen Bereich einer ganzflächig auf ein Hilfssubstrat aufgebrachten mikrostrukturierten NiTi-Schicht.

## Patentansprüche

1. Verfahren zur Herstellung eines Bauteils, das eine Funktionsschicht enthält, bei dem man
a) eine Oberfläche eines ersten, mechanisch und thermisch stabilen Substrats in der Weise mit einer Opferschicht überzieht, dass Randbereiche der Oberfläche freibleiben,
b) auf den Randbereichen der Oberfläche und auf der Opferschicht mit Hilfe einer Maske eine mikrostrukturierte Schicht, bestehend aus einer Formgedächtnislegierung, in der Weise aufbaut, dass
- ein zentraler Bereich der mikrostrukturierten Schicht unmittelbar über der Opferschicht angeordnet und entsprechend den Anforderungen an die Funktionsschicht gestaltet ist,
- ein peripherer Bereich der mikrostrukturierten Schicht über den Randbereichen der Oberfläche angeordnet ist
- der zentrale Bereich mit dem peripheren Bereich über Stege verbunden ist,
c) die Opferschicht selektiv entfernt,
d) den zentralen Bereich als Funktionsschicht mit einem zweiten Substrat verbindet und
e) zusammen mit dem zweiten Substrat durch Zerstören der Stege isoliert.

2. Verfahren nach Anspruch 1 mit einem ersten Substrat bestehend aus Aluminiumoxid.

3. Verfahren nach Anspruch 1 mit einer Opferschicht aus Gold.

4. Verfahren nach Anspruch 3, bei dem die Opferschicht mit einer wässrigen Lösung aus Kaliumjodid und Jod selektiv aufgelöst wird.

5. Verfahren nach Anspruch 1 mit einem zweiten Substrat bestehend aus einem Kunststoff.

## Claims

1. Method of producing a component which contains a functional layer, in which method
a) a surface of a first, mechanically and thermally stable substrate is covered with a disposable layer in such a manner that edge regions of the surface remain free,
b) on the edge regions of the surface and on the disposable layer, with the help of a mask, a microstructured layer, comprising a shape-memorising alloy, is constructed in such a manner that
- a central region of the microstructured layer is disposed directly above the disposable layer, and is configured according to the requirements for the functional layer,
- a peripheral region of the microstructured layer is disposed above the edge regions of the surface, and
- the central region is connected to the peripheral region via webs,
c) the disposable layer is selectively removed,
d) the central region is connected to a second substrate as the functional layer, and
e) isolated, together with the second substrate, by destroying the webs.

2. Method, according to claim 1, using a first substrate which is formed from aluminium oxide.

3. Method according to claim 1, using a disposable layer formed from gold.

4. Method according to claim 3, wherein the disposable layer is selectively dissolved with an aqueous solution of potassium iodide and iodine.

5. Method, according to claim 1, using a second substrate formed from a plastics material.

## Revendications

1. Procédé de fabrication d'un composant ayant une couche fonctionnelle selon lequel :
a) on revêt une surface supérieure d'un premier substrat stable mécaniquement et thermiquement avec une couche sacrificielle de façon à laisser libre les zones marginales de la surface supérieure,
b) sur les zones marginales de la surface supérieure et sur la couche sacrificielle, on réalise à l'aide d'un masque, une couche microstructurée formée d'un alliage à mémoire de forme en procédant comme suit :
- on applique une zone centrale de la couche microstructurée directement sur la couche sacrificielle et on met en forme selon les exigences concernant la couche fonctionnelle ;
- on applique une zone périphérique de la couche microstructurée sur les zones marginales de la surface supérieure ;
- on relie la zone centrale à la zone périphérique par des entretoises ;
c) on enlève sélectivement la couche sacrificielle ;
d) on relie la zone centrale comme couche fonctionnelle à un second substrat ; et
e) on isole avec le second substrat en détruisant les entretoises.

2. Procédé selon la revendication 1,
utilisant un premier substrat en oxyde d'aluminium.

3. Procédé selon la revendication 1,
utilisant une couche sacrificielle en or.

4. Procédé selon la revendication 3,
selon lequel
la couche sacrificielle se dissout sélectivement à l'aide d'une solution aqueuse d'iodure de potassium et d'iode.

5. Procédé selon la revendication 1, appliqué à un second substrat en matière plastique.
